# EUROPEAN PATENT APPLICATION

(11) **EP 4 671 918 A1**
(43) Date of publication of application: **31.12.2025**
(21) Application number: 24760220.4
(22) Date of filing: 14.02.2024
(51) Int. Cl.: G06F 1/20, H05K 7/20

(54) **ELECTRONIC DEVICE**

(30) Priority: 21.02.2023 JP 2023025546
(71) Applicant: Sony Interactive Entertainment Inc., Tokyo 108-0075 (JP)
(72) Inventor: OOTORI, Yasuhiro, Tokyo 108-0075 (JP); MORISHITA, Mitsuharu, Tokyo 108-0075 (JP)
(74) Representative: Fish & Richardson P.C.
(86) International application number: PCT/JP2024/005080
(87) International publication number: WO 2024/176919

(57) **Abstract**

An electronic device (10) includes a cooling fan (40) and a device main body (20) that accommodates the cooling fan (40). The device main body (20) has an upper main body air suction port (22e) formed in an upper surface (22a), a lower main body air suction port (23e) formed in a lower surface (23a), and an auxiliary air flow path (Pc) that extends through the device main body (20) in the up-down direction and that allows an air flow from one of the upper side and the lower side in the device main body (20) to the other side. With this configuration, even if there is a difference in air suction performance between the two main body air suction ports (22e, 23e), the air suction port that has the larger suction performance can be supplied with a sufficient amount of air.

## Description

### [Technical Field]

The present disclosure relates to an electronic device.

### [Background Art]

PCT Patent Publication No. WO2021/193882 discloses an electronic device that can be used as a game device, a video reproduction device, etc. The electronic device has a device main body that accommodates a circuit board, a cooling fan, and the like and two exterior panels that are respectively mounted on the upper surface and the lower surface of the device main body. An air suction port is formed in each of the upper surface and the lower surface of the device main body. The air suction ports are covered with the exterior panels. The cooling fan is driven to introduce air into the device main body through the two air suction ports, and the air is supplied to cool components disposed above the circuit board and components disposed below the circuit board.

### [Summary]

In some cases, a flow of the air is blocked due to the structure of an impeller of the cooling fan or due to arrangement of the components in the device, for example, so that a difference can be generated in air suction performance between the two air suction ports.

An electronic device that is proposed by the present disclosure includes a cooling fan and a device main body that accommodates the cooling fan. The device main body has a first outer surface that is an outer surface on a first side in a first direction, a second outer surface that is an outer surface on a second side which is opposite to the first side in the first direction, a first main body air suction port that is formed in the first outer surface and that introduces air toward the cooling fan, a second main body air suction port that is formed in the second outer surface and that introduces air toward the cooling fan, and an auxiliary air flow path that extends through the device main body in the first direction and that allows an air flow from one of the first side and the second side in the device main body to the other side.

According to this electronic device, even if there is a difference in the air suction performance between the first main body air suction port and the second main body air suction port, the first main body air suction port and the second main body air suction port can each be supplied with an amount of air corresponding to its suction performance via the auxiliary air flow path.

### [Brief Description of Drawings]

[FIG. 1]

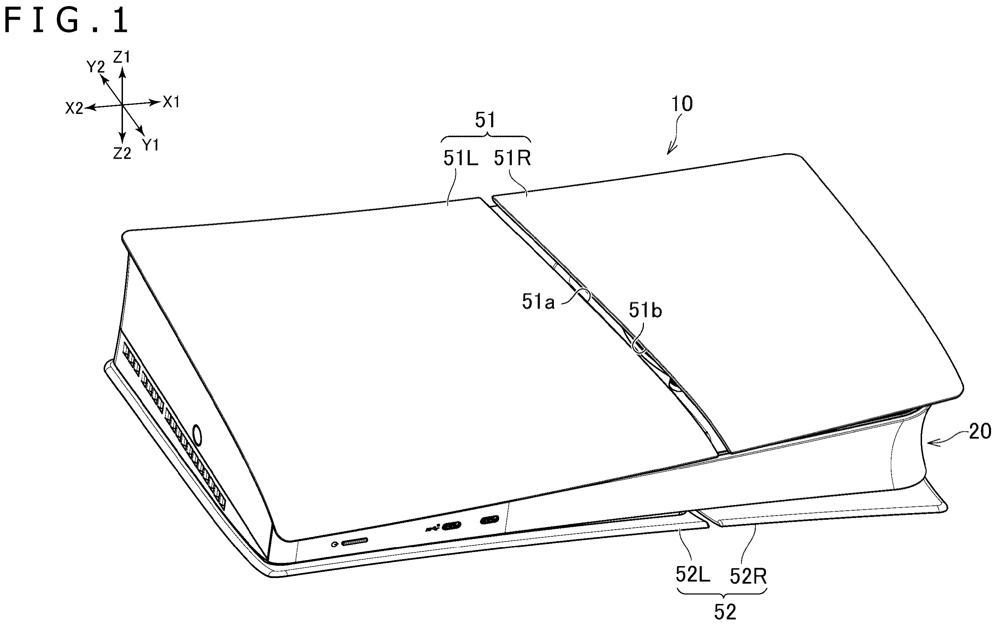

   FIG. 1 is a perspective view of one example of an electronic device that is proposed by the present disclosure.
[FIG. 2]

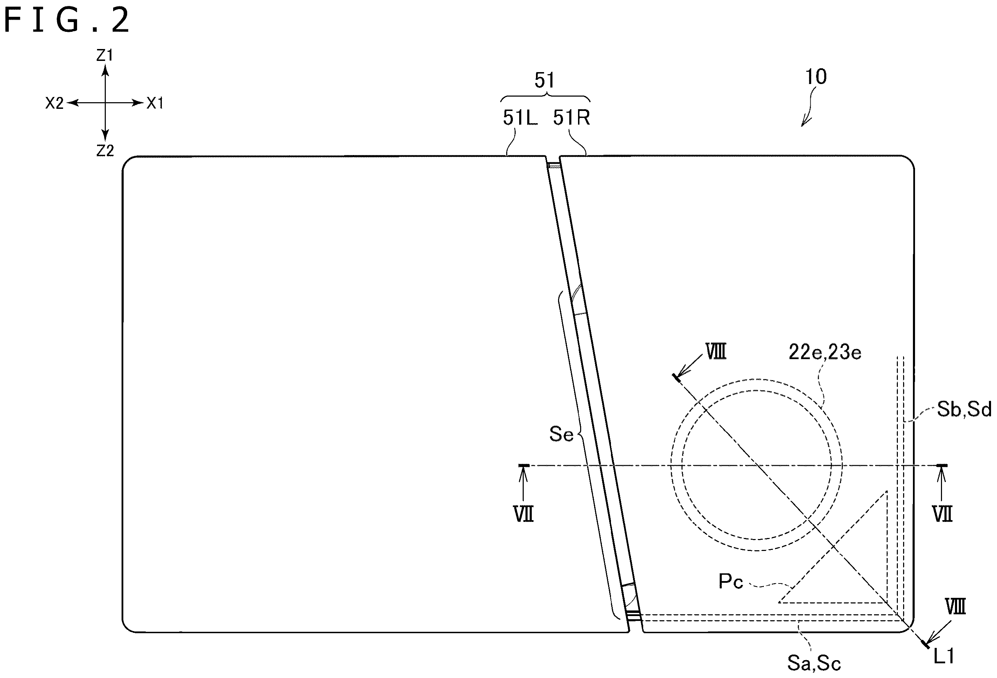

   FIG. 2 is a plan view of the electronic device.
[FIG. 3]

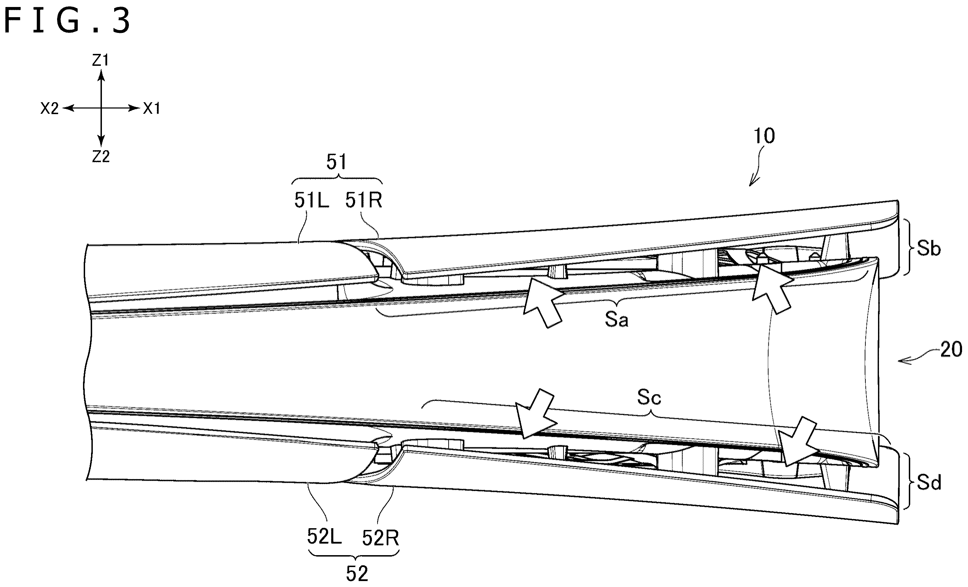

   FIG. 3 is a front view of the electronic device.
[FIG. 4A]

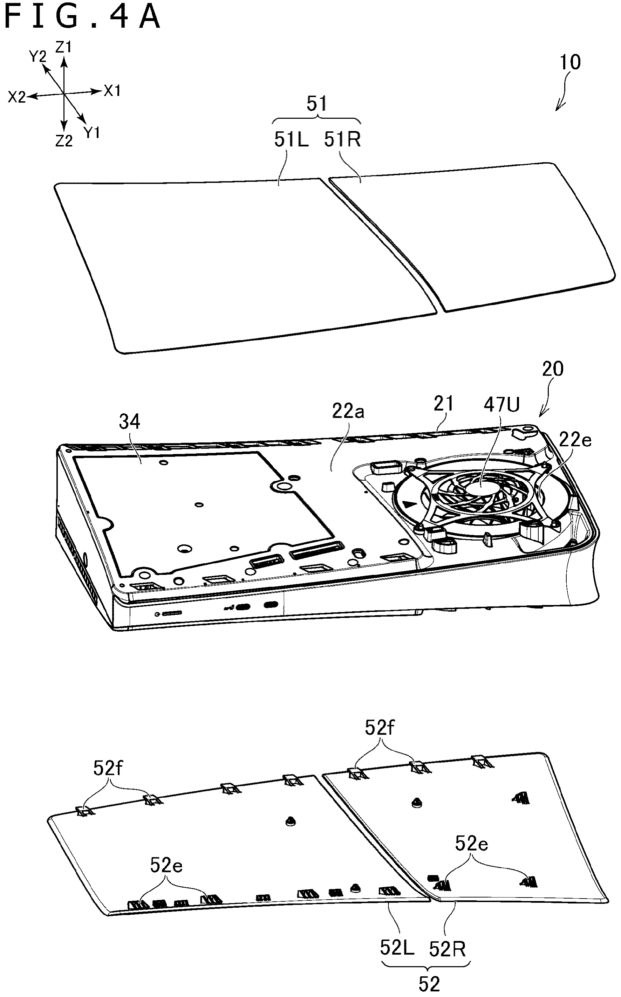

   FIG. 4A is an exploded perspective view of the electronic device and depicts the upper side of a device main body, the upper side of an upper exterior panel, and the upper side of a lower exterior panel.
[FIG. 4B]

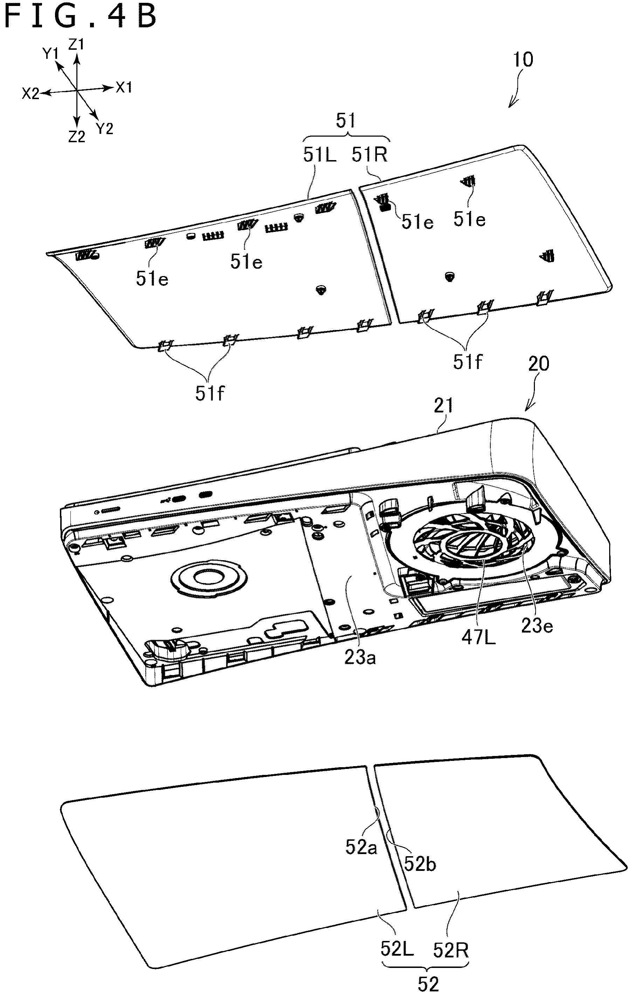

   FIG. 4B is an exploded perspective view of the electronic device and depicts the lower side of the device main body, the lower side of the upper exterior panel, and the lower side of the lower exterior panel.
[FIG. 5]

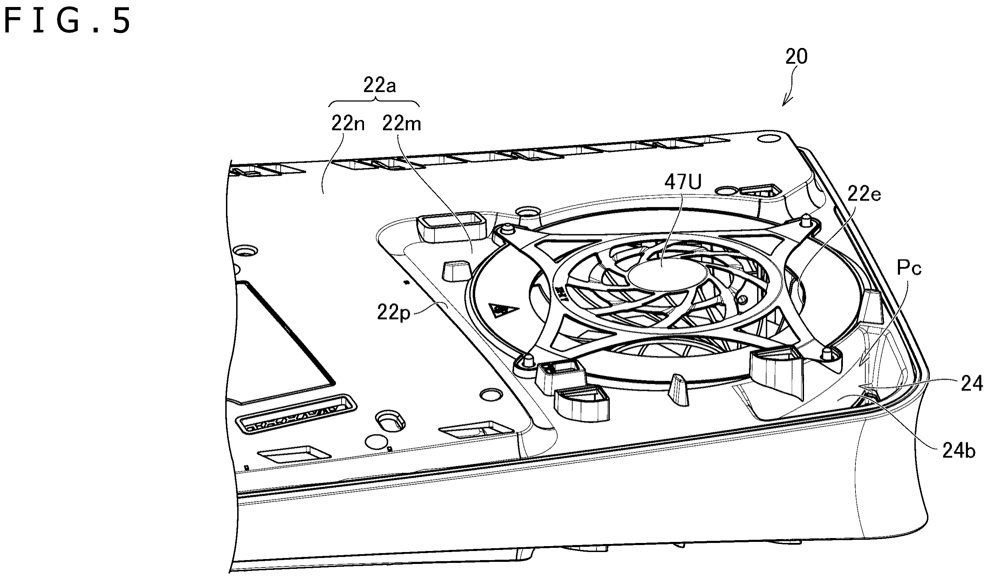

   FIG. 5 is a perspective view of the device main body depicted in FIG. 4A.
[FIG. 6]

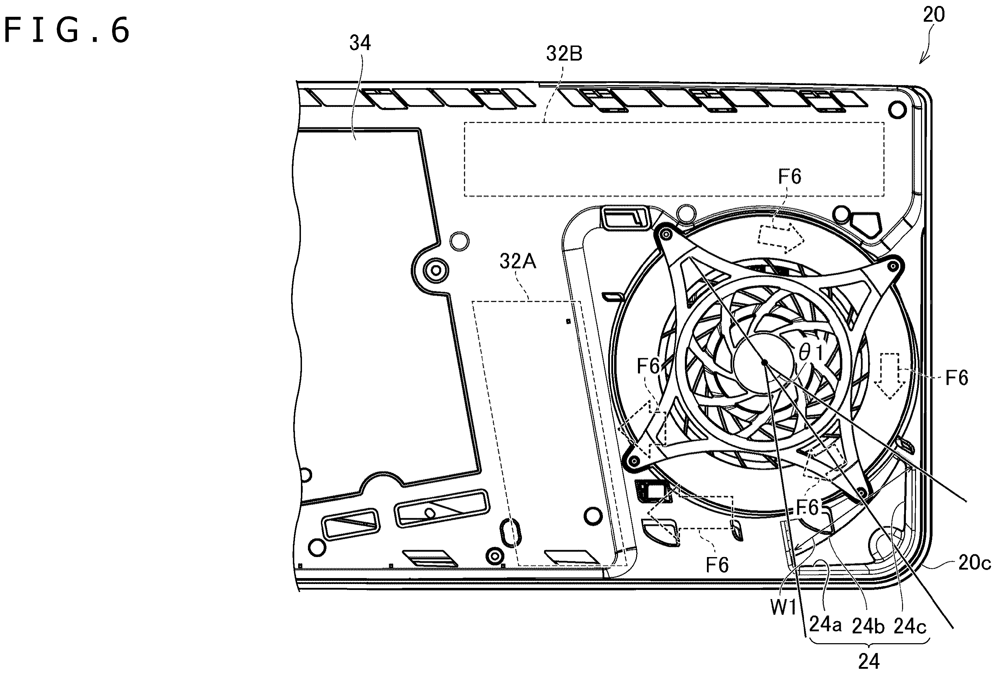

   FIG. 6 is a plan view of the device main body.
[FIG. 7]

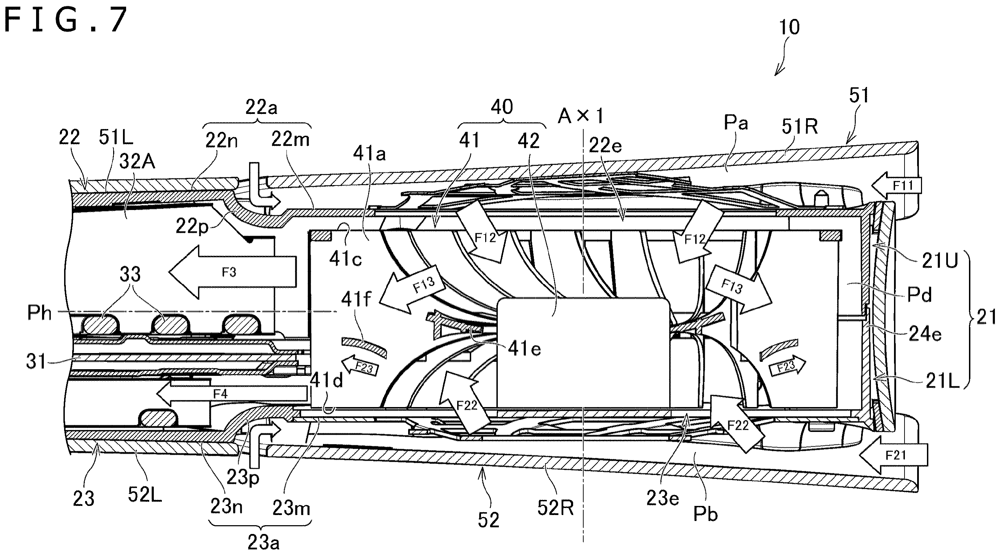

   FIG. 7 is a cross-sectional view taken along line VII-VII in FIG. 2.
[FIG. 8]

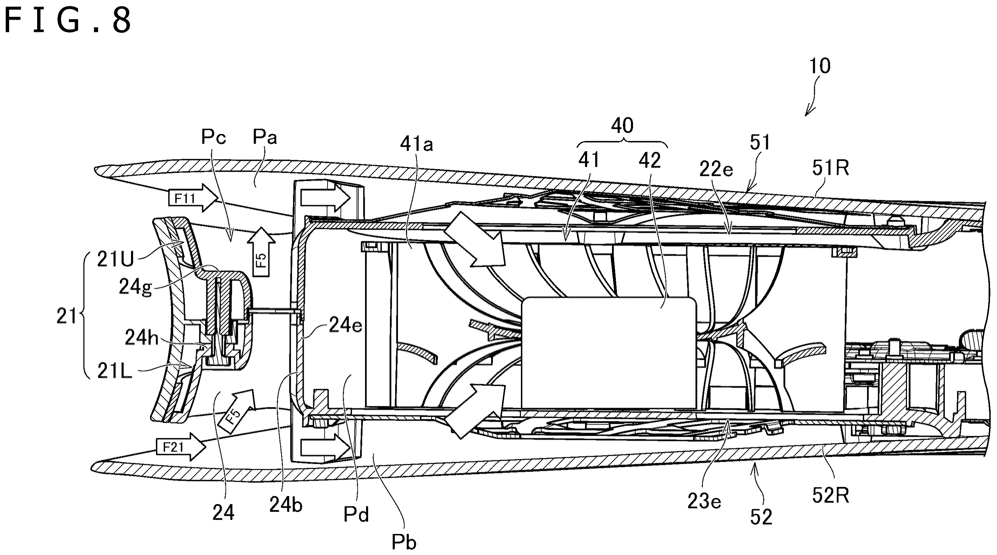

   FIG. 8 is a cross-sectional view taken along line VIII-VIII in FIG. 2.
[FIG. 9A]

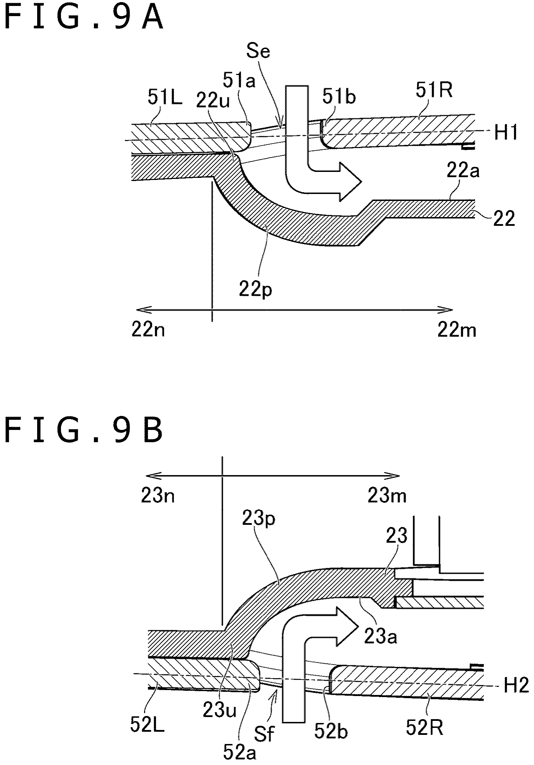

   FIG. 9A is an enlarged view of FIG. 7 and depicts an air suction port formed in the upper exterior panel.
[FIG. 9B]
   FIG. 9B is an enlarged view of FIG. 7 and depicts an air suction port formed in the lower exterior panel.

### [Description of Embodiment]

Hereinafter, an electronic device that is proposed by the present disclosure will be explained with reference to the drawings. As one example, an electronic device 10 will be explained in the present disclosure.

In the following explanation, a Z1 direction and a Z2 direction in FIG. 1, etc., are referred to as an upper side and a lower side, respectively. Also, an X1 direction and an X2 direction are referred to as a right side and a left side, respectively, and a Y1 direction and a Y2 direction are referred to as a front side and a rear side, respectively. These directions are defined in order to describe the shapes of elements (components, members, and sections) of the electronic device 10 and a relative position relation thereamong. Therefore, the directions in the drawings are not intended to limit the posture of the electronic device 10 in use.

### [Electronic device]

The electronic device 10 is an entertainment device that functions as a game device or an audio visual device, for example. The electronic device 10 outputs, to a display device such as a television, video image data generated by execution of a game program, video/sound data obtained over a network, video/sound data obtained from a recording medium such as an optical disk. Alternatively, the electronic device may be a personal computer or a server computer.

As depicted in FIG. 4A, the electronic device 10 includes a device main body 20, an upper exterior panel 51 that covers an upper surface 22a of the device main body 20, and a lower exterior panel 52 that covers a lower surface 23a (see FIG. 4B) of the device main body 20.

As depicted in FIG. 4A, the device main body 20 has a housing 21. The housing 21 accommodates a circuit board 31 (see FIG. 7), for example. The circuit board 31 is mounted with various electronic components including a central processing unit (CPU), a graphical processing unit (GPU), and a memory. In addition, the housing 21 may include a power source device 34 (see FIG. 4A). The power source device 34 receives power from the outside of the electronic device 10, and supplies devices (e.g., the circuit board 31 and the cooling fan 40) included in the device main body 20 with the power for driving the devices.

Further, a cooling fan 40 and heat radiators (e.g., heat sinks 32A and 32B and a heat pipe 33) are disposed in the housing 21 (see FIG. 7). The heat radiators are connected to an electronic component such as a CPU. The cooling fan 40 introduces outside air into the housing 21 and forms an air flow that passes through the heat radiators.

The housing 21 may have an upper housing 21U (see FIG. 7) and a lower housing 21L (see FIG. 7) that are put together in the up-down direction, for example. The upper housing 21U covers the upper side of the circuit board 31, the upper side of the cooling fan 40, and the like. The upper housing 21U has an upper wall 22 that constitutes the upper surface 22a (see FIG. 4A) of the device main body 20. The lower housing 21L covers the lower side of the circuit board 31, the lower side of the cooling fan 40, and the like. The lower housing 21L has a lower wall 23 that constitutes the lower surface 23a (see FIG. 4B) of the device main body 20.

As depicted in FIG. 7, the cooling fan 40 includes an impeller 41 and a driving unit 42. The driving unit 42 accommodates an electric motor. The cooling fan 40 is disposed in such a way that the impeller 41 rotates about an axis Ax1 extending along the up-down direction. The impeller 41 has a plurality of fins 41a that are arranged in the rotation direction of the impeller 41. Each of the fins 41a is connected to an outer peripheral surface of the driving unit 42.

As depicted in FIG. 7, the circuit board 31 is disposed in such a manner as to intersect the up-down direction. In the up-down direction, the position of the circuit board 31 may be between an upper end (upper edge 41c of each fin 41a) of the impeller 41 and a lower end (lower edge 41d of each fin 41a) of the impeller 41. When the cooling fan 40 is driven, air flows outwardly in the radial direction of the impeller 41. Then, above and below the circuit board 31, air flows F3 and F4 are respectively formed along the circuit board 31.

### [Air suction port]

An air suction port 22e (see FIGS. 4A and 7) is formed in the upper surface 22a (i.e., upper wall 22) of the device main body 20. Also, an air suction port 23e (see FIGS. 4B and 7) is formed in the lower wall 23 of the housing 21 (hereinafter, the air suction ports 22e and 23e are referred to as an "upper main body air suction port" and a "lower main body air suction port," respectively). The upper main body air suction port 22e is formed directly above the cooling fan 40. The lower main body air suction port 23e is formed directly below the cooling fan 40. The cooling fan 40 is positioned between the upper main body air suction port 22e and the lower main body air suction port 23e.

As depicted in FIG. 7, an upper air flow path Pa is formed between the upper surface 22a of the device main body 20 and the upper exterior panel 51. A space is ensured between the upper surface 22a of the device main body 20 and the upper exterior panel 51. The space functions as the upper air flow path Pa. As depicted in FIG. 3, air suction ports Sa and Sb are formed between an outer peripheral edge of the upper exterior panel 51 and the device main body 20. Through the air suction ports Sa and Sb, outside air is introduced into the upper air flow path Pa and flows toward the upper main body air suction port 22e.

As depicted in FIG. 3, the air suction ports Sa and Sb are formed, for example, between an edge of the upper exterior panel 51 and an edge of the upper surface 22a of the device main body 20. More specifically, the air suction ports Sa and Sb are formed between front and right edges of a right portion panel 51R, which is to be described later, and an edge of the upper surface 22a of the device main body 20.

The air suction ports Sa and Sb may be open to a direction intersecting the axis Ax1 of the cooling fan 40. By way of example, the air suction port Sa is open to the front side of the electronic device 10 while the air suction port Sb may be open to the right side of the electronic device 10. The air suction ports Sa and Sb may mutually be connected at a corner of the electronic device 10.

The lower portion of the electronic device 10 also has an air suction structure similar to that in the upper portion. That is, as depicted in FIG. 7, a lower air flow path Pb is formed between the lower surface 23a of the device main body 20 and the lower exterior panel 52. A space is ensured between the lower surface 23a of the device main body 20 and the lower exterior panel 52. The space functions as the lower air flow path Pb. As depicted in FIG. 3, air suction ports Sc and Sd are formed between an edge of the lower exterior panel 52 and the device main body 20. Through the air suction ports Sc and Sd, outside air is introduced into the lower air flow path Pb, and flows toward the lower main body air suction port 23e.

As depicted in FIG. 3, the air suction ports Sc and Sd are formed, for example, between an edge of the lower exterior panel 52 and an edge of the lower surface 23a of the device main body 20. More specifically, the air suction ports Sc and Sd are formed between a front edge and a right edge of a right portion panel 52R, which is to be described later, and an edge of the lower surface 23a of the device main body 20.

The air suction ports Sc and Sd may be open to the direction intersecting the axis Ax1 of the cooling fan 40. By way of example, the air suction port Sc may be open to the front side of the electronic device 10 while the air suction port Sd may be open to the right side of the electronic device 10. The air suction ports Sc and Sd may mutually be connected at a corner of the electronic device 10.

The structures of the upper and lower air flow paths Pa and Pb and the air suction ports Sa, Sb, Sc, and Sd are not limited to those illustrated in FIG. 3, etc. By way of example, the exterior panels 51 and 52 may be disposed in such a manner as to allow air introduction from the rear side and/or the left side of the electronic device 10 in addition to from the front and right sides of the electronic device 10.

In another example, the upper portion of the electronic device 10 may have only either one of the air suction port Sa which is open to the front side and the air suction port Sb which is open to the right side. Also, the lower portion of the electronic device 10 may have only either one of the air suction port Sc which is open to the front side and the air suction port Sd which is open to the right side.

In still another example, the upper exterior panel 51 may have an air suction port that is positioned directly above the main body air suction port 22e, in place of the air suction ports Sa and Sb. Also, the lower exterior panel 52 may have an air suction port that is positioned directly below the main body air suction port 23e, in place of the air suction ports Sc and Sb.

The exterior panels 51 and 52 each have a plate-like shape in the example depicted in FIG. 1, etc., but may have a box shape whose upper or lower side is open. That is, an outer peripheral portion of the exterior panel 51 may be bent downwardly to surround outer peripheral surfaces (front surface and right and left side surfaces) of the device main body 20. In this case, the air suction ports Sa and Sb may be formed along the outer peripheral surfaces of the device main body 20. Also, an outer peripheral portion of the exterior panel 52 may be bent upwardly to surround the outer peripheral surfaces (front surface and right and left side surfaces) of the device main body 20. In this case, the air suction ports Sc and Sd may be formed along the outer peripheral surfaces of the device main body 20.

### [Auxiliary air flow path]

As depicted in FIGS. 5 and 8, the device main body 20 has an auxiliary air flow path Pc. The auxiliary air flow path Pc extends through the device main body 20 in the up-down direction. The housing 21 of the device main body 20 has a tubular flow path wall 24. The auxiliary air flow path Pc is defined by the tubular flow path wall 24.

Air introduced from the outside can pass through the auxiliary air flow path Pc from one of the lower side and the upper side in the device main body 20 to the other side. In the example explained in the present disclosure, air flows from the lower side toward the upper side in the device main body 20 (FIG. 8 depicts an air flow F5 passing through the auxiliary air flow path Pc). Even in a case where there is a difference in the air suction performance between the upper main body air suction port 22e and the lower main body air suction port 23e, the main body air suction ports 22e and 23e can each be supplied with an amount of air corresponding to its suction performance via the auxiliary air flow path Pc. Specifically, a sufficient amount of air can be supplied to the air suction port that has larger suction performance via the auxiliary air flow path Pc.

The auxiliary air flow path Pc may be formed inside an outer surface of the electronic device 10 (more specifically, the outer peripheral surface of the device main body 20). That is, the auxiliary air flow path Pc may not be exposed to the outer surface of the electronic device 10. Accordingly, the air flow F5 can be formed from the lower side toward the upper side in the device main body 20 while the influence of the auxiliary air flow path Pc on the appearance of the electronic device 10 is suppressed.

As depicted in FIG. 7, the impeller 41 of the cooling fan 40 has guide sections 41e and 41f between the upper end (upper edge 41c of each fin 41a) and the lower end (lower edge 41d of each fin 41a). The guide sections 41e and 41f extend in the rotation direction of the impeller 41, and couple the plurality of fins 41a to each other. The guide sections 41e and 41f may each be formed into an annular shape and couple all the fins 41a to each other.

As depicted in FIG. 7, when the cooling fan 40 is being driven, air (an air flow F12) introduced into the device main body 20 through the upper main body air suction port 22e is guided outwardly in the radial direction by the guide sections 41e and 41f. Then, the air forms the air flow F3 above the circuit board 31. Also, air (an air flow F22) introduced into the device main body 20 through the lower main body air suction port 23e is guided outwardly in the radial direction by the guide sections 41e and 41f. Then, the air forms the air flow F4 below the circuit board 31.

As depicted in FIG. 7, the position of the circuit board 31 in the up-down direction is lower than a horizontal plane Ph that passes through the center between the upper end (upper edge 41c) and the lower end (lower edge 41d) of the impeller 41 (that is, the circuit board 31 is rather close to the lower edge 41d of each fin 41a). In accordance with the position of the circuit board 31, the positions of the guide sections 41e and 41f are also lower than the horizontal plane Ph.

The air suction ports Sa and Sb (see FIG. 3) disposed in the upper portion of the electronic device 10 and the air suction ports Sc and Sd (see FIG. 3) disposed in the lower portion have substantially the same size, and amounts of air passing through these ports are also substantially equal to each other. Meanwhile, the air suction performance for air from above the cooling fan 40 and the suction performance for air from below the cooling fan 40 are not balanced due to the positions of the guide sections 41e and 41f. Specifically, the positions of the guide sections 41e and 41f are rather close to the lower end side of the impeller 41, so that the suction performance for air from above the cooling fan 40 (suction performance of the upper main body air suction port 22e) is larger than the suction performance for air from below the cooling fan 40 (suction performance of the lower main body air suction port 23e). Thus, air introduced from the air suction ports Sc and Sd which are disposed in the lower portion of the electronic device 10 upwardly passes through the auxiliary air flow path Pc (see the air flow F5 in FIG. 8). Then, the air is introduced into the housing 21 through the upper main body air suction port 22e. Accordingly, the suction performance for air from above the cooling fan 40 and the suction performance for air from below the cooling fan 40 can each adequately be exerted.

As depicted in FIG. 7, the impeller 41 has the two guide sections 41e and 41f. The guide section 41f is positioned radially outside the guide section 41e. A space is formed between an outer peripheral edge of the inside guide section 41e and an inner peripheral edge of the outside guide section 41f. In this space, an air flow is formed. With the two guide sections 41e and 41f, an appropriate balance can easily be achieved between the air flow F3 which is formed above the circuit board 31 and the air flow F4 which is formed below the circuit board 31.

It is to be noted that, unlike the example depicted in FIG. 7, the number of the guide sections included in the impeller 41 may be one, or may be larger than two. Alternatively, neither of the guide sections may be provided to the impeller 41.

As depicted in FIG. 8, the auxiliary air flow path Pc connects the upper air flow path Pa which is formed on the upper side in the device main body 20 to the lower air flow path Pb which is formed on the lower side in the device main body 20. Thus, part of air flowing through one of the air flow paths Pa and Pb is added via the auxiliary air flow path Pc to the other one of the air flow paths Pa and Pb. In the example depicted in FIG. 8, part of air flowing through the lower air flow path Pb (F5 in FIG. 8) is added via the auxiliary air flow path Pc to the upper air flow path Pa, as previously explained. Accordingly, the suction performance for air from above the cooling fan 40 and the suction performance for air from below the cooling fan 40 can each adequately be exerted.

As depicted in FIG. 8, the auxiliary air flow path Pc is open upwardly. The upward opening of the auxiliary air flow path Pc is covered with the upper exterior panel 51. With this configuration, air having passed through the auxiliary air flow path Pc is guided toward the upper main body air suction port 22e by the upper exterior panel 51.

When the electronic device 10 is viewed in a plan view, the auxiliary air flow path Pc may be entirely covered with the upper exterior panel 51. The front edge and right edge of the upper exterior panel 51, or more specifically, the front edge and right edge of the right portion panel 51R, which is to be described later, are expanded to the front side and right side beyond the positions of the outer peripheral surfaces (front surface and right side surface) of the device main body 20. Accordingly, the auxiliary air flow path Pc can be prevented from being exposed. Unlike the example depicted in the drawing, the auxiliary air flow path Pc may be partially exposed from the upper exterior panel 51.

Further, as depicted in FIG. 8, the auxiliary air flow path Pc is open downwardly. This opening is covered with the lower exterior panel 52. With this configuration, part of air having been introduced from the air suction ports Sc and Sd after passing above the lower exterior panel 52 flows into the auxiliary air flow path Pc.

When the electronic device 10 is viewed from the bottom side, the auxiliary air flow path Pc may be entirely covered with the lower exterior panel 52. The front edge and right edge of the lower exterior panel 52, or more specifically, the front edge and right edge of the right portion panel 52R, which is to be described later, are expanded to the front side and the right side beyond the positions of the outer peripheral surfaces (front surface and right side surface) of the device main body 20. Accordingly, the auxiliary air flow path Pc can be prevented from being exposed when, for example, the electronic device 10 is held in an upright position. Unlike the example depicted in the drawing, the auxiliary air flow path Pc may be partially exposed from the lower exterior panel 52.

In contrast to the example depicted in the drawing, the cooling fan 40 may be disposed in such a way that the suction performance for air from below the cooling fan 40 becomes larger than the suction performance for air from above the cooling fan 40. In this case, part of air introduced from the air suction ports Sa and Sb which are disposed in the upper portion of the electronic device 10 flows into the auxiliary air flow path Pc. Then, the air may pass through the auxiliary air flow path Pc to the lower side in the device main body 20.

### [Position of auxiliary air flow path]

As depicted in FIG. 2, when the electronic device 10 is viewed from the up-down direction (axis direction of the cooling fan 40), the auxiliary air flow path Pc is positioned outside the main body air suction ports 22e and 23e. Specifically, the auxiliary air flow path Pc is positioned between the main body air suction port 22e and the air suction ports Sa and Sb. Also, the auxiliary air flow path Pc is positioned between the main body air suction port 23e and the air suction ports Sc and Sd. In other words, a straight line L1 that passes through the center of the main body air suction ports 22e and 23e and the air suction ports Sa, Sb, Sc, and Sd intersects the auxiliary air flow path Pc.

Since the auxiliary air flow path Pc is positioned between the main body air suction port 23e and the air suction ports Sc and Sd, an air flow from the air suction ports Sc and Sd toward the auxiliary air flow path Pc can smoothly be formed. In addition, since the auxiliary air flow path Pc is positioned between the main body air suction port 22e and the air suction ports Sa and Sb, air coming out from the auxiliary air flow path Pc is added to an air flow from the air suction ports Sa and Sb toward the upper main body air suction port 22e.

The straight line L1 in FIG. 2 may be a straight line passing through the center of the main body air suction ports 22e and 23e. Further, the straight line L1 may be a straight line passing through a substantial center of the air suction ports Sa, Sb, Sc, and Sd (connection point between the air suction ports Sa and Sc on the front side and the air suction ports Sb and Sd on the right side). Moreover, the auxiliary air flow path Pc may be formed in such a way that the straight line L1 intersects a substantial center of a width W1 (see FIG. 6) of the auxiliary air flow path Pc.

The position of the auxiliary air flow path Pc is not limited to the example depicted in FIG. 6. By way of example, the substantial center of the width W1 of the auxiliary air flow path Pc may be deviated from the straight line L1.

As depicted in FIG. 6, the auxiliary air flow path Pc is positioned between a corner 20c of the device main body 20 and the upper and lower main body air suction ports 22e and 23e. More specifically, the main body air suction ports 22e and 23e are formed in the front right portion of the device main body 20. The auxiliary air flow path Pc is positioned between the corner 20c at the front right side of the device main body 20 and the main body air suction ports 22e and 23e. Accordingly, a region (region around the corner) that is likely to become a dead space in the device main body 20 is effectively used to form the auxiliary air flow path Pc.

As depicted in FIG. 7, the upper exterior panel 51 may be curved in such a way that the distance between the upper surface 22a and the upper exterior panel 51 gradually increases toward the corner 20c of the device main body 20. Also, the lower exterior panel 52 may be curved in such a way that the distance between the lower surface 23a and the lower exterior panel 52 gradually increases toward the corner 20c of the device main body 20. With this configuration, an air flow passing through the auxiliary air flow path Pc can be smoothed.

### [Size of auxiliary air flow path]

The cooling fan 40 is disposed with the impeller 41 rotatable about the axis Ax1 extending along the up-down direction, as previously explained. As depicted in FIG. 6, an angle range θ1 of the auxiliary air flow path Pc in a circumferential direction centered on the axis Ax1 may be 10 degrees or larger. With this configuration, an air flow can easily be formed inside the auxiliary air flow path Pc.

The angle range θ1 of the auxiliary air flow path Pc is preferably 20 degrees or larger. The angle range θ1 is more preferably 30 degrees or larger. The angle range θ1 may be 40 degrees or larger. With an increase of the angle range θ1, an amount of air to pass through the auxiliary air flow path Pc can be increased.

The angle range θ1 may be equal to or smaller than 60 degrees. With such a limitation on the angle range θ1, the influence on arrangement of components in the device main body 20 can be reduced.

Inner surfaces of the auxiliary air flow path Pc may include a surface 24c along the right side surface of the device main body 20 and a surface 24a along the front surface of the device main body 20, as depicted in FIG. 6. The inner surfaces of the auxiliary air flow path Pc may include an inclined surface 24b that intersects the straight line L1. That is, the auxiliary air flow path Pc may have a substantially triangular shape formed by the three surfaces (24c, 24a, and 24b). According to this shape of the auxiliary air flow path Pc, the size of the auxiliary air flow path Pc can be increased between the corner 20c of the device main body 20 and the main body air suction ports 22e and 23e. The front surface of the device main body 20 is a surface on which a power button of the electronic device 10, a connector, etc., are disposed.

It is to be noted that the shape of the auxiliary air flow path Pc is not limited to the substantially triangular shape. The auxiliary air flow path Pc may be circular or elliptical.

An air flow path Pd (see FIGS. 7 and 8) that is formed radially outside the impeller 41 is included in the device main body 20 (inside of the housing 21). An air flow F6 which is depicted in FIG. 6 is formed in the air flow path Pd. The housing 21 has a flow path wall 24e (see FIGS. 7 and 8). The flow path wall 24e is curved in such a manner as to surround the impeller 41, and the air flow path Pd is formed between the flow path wall 24e and the impeller 41.

The housing 21 has the tubular flow path wall 24 that defines the auxiliary air flow path Pc, as previously explained. The tubular flow path wall 24 includes a wall portion constituting the inclined surface 24b (see FIG. 6). Part of the flow path wall 24e surrounding the impeller 41 constitutes the inclined surface 24b of the tubular flow path wall 24. That is, the air flow path Pd (see FIGS. 7 and 8) is formed inside the flow path wall 24e surrounding the impeller 41, and the auxiliary air flow path Pc is formed outside the flow path wall 24e.

The housing 21 includes the upper housing 21U and the lower housing 21L that are put together in the up-down direction. As depicted in FIG. 8, the upper housing 21U includes an upper portion of the tubular flow path wall 24 defining the auxiliary air flow path Pc. The lower housing 21L includes a lower portion of the tubular flow path wall 24. The upper portion of the tubular flow path wall 24 may have a connection section 24g. The lower portion of the tubular flow path wall 24 may have a connection section 24h. The connection sections 24g and 24h are fixed to each other with a fixing tool such as a screw.

### [Upper panel air suction port]

As depicted in FIG. 4A, the upper exterior panel 51 includes two exterior panels arranged side by side in the left-right direction. That is, the upper exterior panel 51 has a left portion panel 51L that covers a left portion of the upper surface 22a of the device main body 20 and a right portion panel 51R that covers a right portion of the upper surface 22a.

As depicted in FIG. 9A, a space that functions as an air suction port Se is ensured between the left portion panel 51L and the right portion panel 51R. The left portion panel 51L and the right portion panel 51R respectively have a right edge 51a and a left edge 51b that are opposed to each other in the left-right direction. The space is ensured between the edges 51a and 51b of the portion panels 51L and 51R, that is, between the right end surface of the left portion panel 51L and the left end surface of the right portion panel 51R, and functions as the air suction port Se.

Since the space between the left portion panel 51L and the right portion panel 51R is also used as the air suction port Se, the cooling performance can easily be further improved, compared to a case, for example, where only the air suction ports Sa and Sb are used. Hereinafter, the air suction port Se is referred to as an "upper panel air suction port."

As depicted in FIG. 7, the upper main body air suction port 22e formed in the device main body 20 is entirely covered with the right portion panel 51R. That is, the upper main body air suction port 22e is not exposed from the space between the portion panels 51R and 51L. With this configuration, foreign objects such as dust can be inhibited from entering the upper main body air suction port 22e.

The upper main body air suction port 22e is covered with a cover 47U (see FIG. 4A) having a plurality of openings formed therein. The cover 47U prevents foreign objects from entering the device main body 20 through the main body air suction port 22e. The right portion panel 51R may completely cover the cover 47U.

The air suction ports Sa and Sb (see FIG. 3) are formed between an outer edge of the upper exterior panel 51 and an outer peripheral edge of the device main body 20, as previously explained. Therefore, air introduced from the air suction ports Sa and Sb and air introduced from the upper panel air suction port Se are introduced from the upper main body air suction port 22e (see FIG. 7) via the upper air flow path Pa. Accordingly, the cooling performance in the electronic device 10 can be improved.

As depicted in FIG. 3, the air suction ports Sa and Sb are open to the direction intersecting the axis Ax1 of the cooling fan 40. Specifically, the air suction port Sa is open to the front side of the electronic device 10, and the air suction port Sb is open to the right side of the electronic device 10. On the other hand, the upper panel air suction port Se is open to the upper side. Therefore, the air suction ports Sa and Sb and the upper panel air suction port Se are respectively open to directions that are orthogonal to each other.

The right portion panel 51R and the left portion panel 51L may independently be removable from the device main body 20. That is, only the right portion panel 51R may be removed from the device main body 20, and only the left portion panel 51L may be removed from the device main body 20. Engagement projection sections 51e and 51f (see FIG. 4B) to be engaged with the upper surface 22a of the device main body 20 are formed on the lower surfaces of the respective portion panels 51R and 51L.

No structure for coupling the right edge 51a (see FIG. 9A) of the left portion panel 51L and the left edge 51b (see FIG. 9A) of the right portion panel 51R to each other is formed therebetween. Accordingly, air outside the electronic device 10 can smoothly pass through the upper panel air suction port Se.

As depicted in FIG. 1, the edges 51a and 51b of the portion panels 51L and 51R are substantially parallel to each other. Accordingly, the width of the space between the edges 51a and 51b can be suppressed from excessively increase. As a result, an exposed range of the upper surface 22a of the device main body 20 from the space can be reduced. The width of the space between the portion panels 51L and 51R may be determined in such a manner as to reduce the influence on the appearance of the electronic device 10.

As depicted in FIG. 2, the edges 51a and 51b of the portion panels 51L and 51R may extend diagonally with respect to both the front-rear direction and the left-right direction of the electronic device 10. The edges 51a and 51b may linearly extend in a plan view of the electronic device 10.

As depicted in FIG. 2, the space between the edges 51a and 51b of the portion panels 51L and 51R extends from a rear edge to a front edge of the upper exterior panel 51. With this structure, a sufficient length of the upper panel air suction port Se can easily be ensured. Only part (e.g., a center portion and a front portion) of the space in the length direction may function as the upper panel air suction port Se. On the contrary, the entirety of the space may function as the upper panel air suction port Se.

As depicted in FIG. 9A, the right edge 51a of the left portion panel 51L may be flush with the left edge 51b of the right portion panel 51R. That is, a surface of the portion panel 51L and a surface of the portion panel 51R may be positioned in the same plane H1 around the edges 51a and 51b. With this structure of the portion panels 51L and 51R, foreign matter can be inhibited from being caught on the edges 51a and 51b of the portion panels 51L and 51R, and the edges 51a and 51b can be protected against damages. It is to be noted that, unlike the example depicted in FIG. 9A, etc., the positions of the right edge 51a of the left portion panel 51L and the left edge 51b of the right portion panel 51R in the up-down direction may be displaced from each other.

As depicted in FIG. 5, the upper surface 22a of the device main body 20 has a first region 22m and a second region 22n. The upper main body air suction port 22e is formed in the first region 22m. The first region 22m is covered with the right portion panel 51R of the upper exterior panel 51. The upper air flow path Pa (see FIG. 7) is formed between the first region 22m and the right portion panel 51R of the upper exterior panel 51. The first region 22m is a region corresponding to the upper air flow path Pa.

As depicted in FIG. 5, the first region 22m of the upper surface 22a is recessed from the remaining region (second region 22n). In other words, the distance from the horizontal plane Ph (see FIG. 7) to the upper wall 22 in the second region 22n is larger than the distance from the horizontal plane Ph to the upper wall 22 in the first region 22m. The second region 22n may have a portion positioned on the left side of the first region 22m and a portion positioned on the rear side of the first region 22m, as depicted in FIG. 5. The upper surface 22a of the device main body 20 may be in contact with the upper exterior panel 51 in the second region 22n.

Since the distance from the horizontal plane Ph to the upper wall 22 in the second region 22n is large, the device main body 20 is allowed to have a large volume in the second region 22n. In the second region 22n, for example, the heat sink 32A (see FIG. 7) may be disposed below the upper wall 22.

As depicted in FIG. 5, an outer peripheral portion of the first region 22m of the upper surface 22a may have an inclined region 22p. The inclined region 22p may surround the upper main body air suction port 22e. In more detail, the inclined region 22p may be formed on the left side and the rear side of the upper main body air suction port 22e. The heat sink 32A may be partially positioned below the inclined region 22p, as depicted in FIG. 7. Accordingly, the size of the heat sink 32A in the left-right direction can be increased.

As depicted in FIG. 9A, the position of the inclined region 22p corresponds to a space (the upper panel air suction port Se) between the edges 51a and 51b of the portion panels 51L and 51R. That is, the inclined region 22p is positioned below the upper panel air suction port Se. Air introduced from the upper panel air suction port Se is guided toward the upper main body air suction port 22e by the inclined region 22p.

As depicted in FIG. 9A, the upper surface 22a of the device main body 20 expands to the right edge 51a of the left portion panel 51L. A boundary 22u between the above-described inclined region 22p and second region 22n is positioned under the left portion panel 51L.

### [Lower panel air suction port]

The upper panel air suction port Se is formed in the upper portion of the electronic device 10 in the above-mentioned manner. The lower portion of the electronic device 10 has an air suction structure similar to that in the upper portion.

Specifically, as depicted in FIG. 4B, the lower exterior panel 52 also includes the two exterior panels 52R and 52L that are arranged side by side in the left-right direction. That is, the lower exterior panel 52 has a left portion panel 52L that covers a left portion of the lower surface 23a of the device main body 20 and a right portion panel 52R that covers a right portion of the lower surface 23a.

As depicted in FIG. 9B, a space that functions as an air suction port Sf is ensured between the left portion panel 52L and the right portion panel 52R. The left portion panel 52L and the right portion panel 52R respectively include a right edge 52a and a left edge 52b that are opposed to each other in the left-right direction. The space is ensured between the right edge 52a of the left portion panel 52L and the left edge 52b of the right portion panel 52R, that is, between the right end surface of the left portion panel 52L and the left end surface of the right portion panel 52R, and functions as the air suction port Sf.

Since the space between the left portion panel 52L and the right portion panel 52R is also used as the air suction port Sf, the cooling performance can easily be further improved, compared to a case, for example, where only the air suction ports Sc and Sd are used. Hereinafter, the air suction port Sf is referred to as a "lower panel air suction port."

As depicted in FIG. 7, the lower main body air suction port 23e is entirely covered with the right portion panel 52R. Therefore, that is, the lower main body air suction port 23e is not exposed from the space between the portion panels 52R and 52. With this configuration, foreign objects such as dust can be inhibited from directly entering the lower main body air suction port 23e.

The lower main body air suction port 23e is covered with a cover 47L (see FIG. 4B) having a plurality of openings formed therein. The cover 47L prevents foreign objects from entering the device main body 20 through the main body air suction port 23e. The right portion panel 52R may completely cover the cover 47L.

The air suction ports Sc and Sd (see FIG. 3) are formed between an outer edge of the lower exterior panel 52 and the outer peripheral edge of the device main body 20, as previously explained. Air introduced from the air suction ports Sc and Sd and air introduced from the lower panel air suction port Sf are introduced from the lower main body air suction port 23e (see FIG. 7) via the lower air flow path Pb. Accordingly, the cooling performance in the electronic device 10 can be improved.

As depicted in FIG. 3, the air suction ports Sc and Sd are open to the direction intersecting the axis Ax1 of the cooling fan 40. Specifically, the air suction port Sc is open to the front side of the electronic device 10, and the air suction port Sd is open to the right side of the electronic device 10. On the other hand, the lower panel air suction port Sf is open to the lower side. In such a manner, the air suction ports Sc and Sd and the lower panel air suction port Sf are respectively open to directions that are orthogonal to each other.

Like the portion panels 51R and 51L of the upper exterior panel 51, the portion panels 52R and 52L may independently be removable from the device main body 20. Engagement projection sections 52e and 52f (see FIG. 4A) to be engaged with the upper surface 22a of the device main body 20 are formed on the lower surfaces of the respective portion panels 52R and 52L.

No structure for coupling the right edge 52a of the left portion panel 52L and the left edge 52b of the right portion panel 52R to each other is formed therebetween. Accordingly, outside air can smoothly pass through the lower panel air suction port Sf.

The edges 52a and 52b of the portion panels 52L and 52R may be substantially parallel to each other. Accordingly, the width of the space between the edges 52a and 52b can be suppressed from excessively increase. As a result, an exposed range of the lower surface 23a of the device main body 20 from the space can be reduced. The width of the space between the edges 52a and 52b of the portion panels 52L and 52R may be determined in such a manner as to reduce the influence on the appearance of the electronic device 10.

The edges 52a and 52b of the portion panels 52L and 52R may extend diagonally with respect to both the front-rear direction and the left-right direction of the electronic device 10. The edges 52a and 52b may linearly extend in a plan view of the electronic device 10.

As depicted in FIG. 4B, the space between the edges 52a and 52b of the portion panels 52L and 52R extends from the rear edge to the front edge of the lower exterior panel 52. With this structure, a sufficient length of the lower panel air suction port Sf can easily be ensured. Only part (e.g., a center portion and a front portion) of the space in the length direction may function as the lower panel air suction port Sf. On the contrary, the entirety of the space may function as the lower panel air suction port Sf.

As depicted in FIG. 9B, the right edge 52a of the left portion panel 52L may be flush with the left edge 52b of the right portion panel 52R. That is, a surface of the portion panel 52L and a surface of the portion panel 52R may be positioned in the same plane H2 around the edges 52a and 52b. With this structure of the portion panels 52L and 52R, foreign matter can be inhibited from being caught on the edges 52a and 52b of the portion panels 52L and 52R, and the edges 52a and 52b can be protected against damages. It is to be noted that, unlike the example depicted in FIG. 9B, etc., the positions of the right edge 52a of the left portion panel 52L and the left edge 52b of the right portion panel 52R in the up-down direction may be displaced from each other.

As depicted in FIG. 7, the lower surface 23a of the device main body 20 has a first region 23m and a second region 23n. The lower main body air suction port 23e is formed in the first region 23m. The first region 23m is covered with the right portion panel 51R of the upper exterior panel 51. The lower air flow path Pb is formed between the first region 23m and the right portion panel 51R of the upper exterior panel 51. The first region 23m is a region corresponding to the lower air flow path Pb.

As depicted in FIG. 7, the first region 23m of the lower surface 23a of the device main body 20 is recessed from the remaining region (second region 23n). In other words, the distance from the horizontal plane Ph (see FIG. 7) to the lower wall 23 in the second region 23n is larger than the distance from the horizontal plane Ph to the lower wall 23 in the first region 23m. The lower surface 23a of the device main body 20 may be in contact with the lower exterior panel 52 in the second region 23n. Since the distance from the horizontal plane Ph to the lower wall 23 in the second region 23n is large as described above, the device main body 20 is allowed to have a large volume in the second region 23n.

As depicted in FIG. 9B, an outer peripheral portion of the first region 23m of the lower surface 23a may have an inclined region 23p. The inclined region 23p may surround the lower main body air suction port 23e. In more detail, the inclined region 23p may be formed on the left side and the rear side of the lower main body air suction port 23e.

As depicted in FIG. 9B, the position of the inclined region 23p corresponds to a space (the lower panel air suction port Sf) between the edges 52a and 52b of the portion panels 52L and 52R. That is, the inclined region 23p is positioned above the lower panel air suction port Sf. Air introduced from the lower panel air suction port Sf is guided toward the lower main body air suction port 23e by the lower surface 23a in the inclined region 23p.

As depicted in FIG. 9B, the lower surface 23a of the device main body 20 expands to the right edge 52a of the left portion panel 52L. A boundary 23u between the above-described inclined region 23p and second region 23n is positioned above the left portion panel 51L.

### [Summary of structure related to auxiliary air flow path]

(1) An electronic device includes a cooling fan and a device main body that accommodates the cooling fan. The device main body has a first outer surface that is an outer surface on a first side in a first direction, a second outer surface that is an outer surface on a second side which is opposite to the first side in the first direction, a first main body air suction port that is formed in the first outer surface and that introduces air toward the cooling fan, a second main body air suction port that is formed in the second outer surface and that introduces air toward the cooling fan, and an auxiliary air flow path that extends through the device main body in the first direction and that allows an air flow from one of the first side and the second side in the device main body to the other side. With this configuration, even if there is a difference in the air suction performance between the first main body air suction port and the second main body air suction port, the first main body air suction port and the second main body air suction port can each be supplied with an amount of air corresponding to its suction performance via the auxiliary air flow path.
(2) In the electronic device according to (1), the cooling fan may include an impeller that is rotatable about an axis extending along the first direction. The cooling fan may be positioned between the first main body air suction port and the second main body air suction port. With this configuration, air can efficiently be sucked from the first main body air suction port and the second main body air suction port.
(3) In the electronic device according to (1) or (2), the impeller may have a plurality of fins. The impeller may have a first end in the first direction, a second end that is an end opposite to the first end, and a guide section that is positioned between the first end and the second end and couples the plurality of fins to each other to guide air outwardly in a radial direction. With this configuration, air can appropriately be sent to the upper and lower surfaces of the electronic device accommodated in the device main body.
(4) In the electronic device according to (3), the guide section may be positioned on the first side with respect to a center of the impeller in the first direction, and air may flow from the first side to the second side in the device main body via the auxiliary air flow path. With this configuration, a sufficient amount of air can be supplied to the first main body air suction port.
(5) In the electronic device according to (1) to (4), the device main body may have a housing. The housing may have a tubular flow path wall constituting the auxiliary air flow path.
(6) The electronic device according to (1) to (5) may have a first exterior panel that covers the first outer surface of the device main body. A first air flow path through which air passes toward the first main body air suction port may be formed between the first outer surface of the device main body and the first exterior panel.
(7) The electronic device according to (1) to (6) may have a first exterior panel that covers the first outer surface of the device main body. The first exterior panel may cover the auxiliary air flow path. With this configuration, the auxiliary air flow path can be inhibited from being conspicuous in the appearance of the electronic device.
(8) The electronic device according to (6) may have a second exterior panel that covers the second outer surface of the device main body. A second air flow path through which air passes toward the second main body air suction port may be formed between the second outer surface of the device main body and the second exterior panel.
(9) In the electronic device according to (8), the auxiliary air flow path may connect the first air flow path to the second air flow path. With this configuration, air passing through the auxiliary air flow path can be guided by the first exterior panel and the second exterior panel.
(10) In the electronic device according to (6), a first air suction port for introducing air to the first air flow path may be formed between an edge of the first exterior panel and the device main body. The auxiliary air flow path may be positioned between the first air suction port and the first main body air suction port. With this configuration, part of air flowing from the first air suction port toward the main body air suction ports flows into the auxiliary air flow path.
(11) The electronic device according to (10) may have a second exterior panel that covers the second outer surface of the device main body. A second air flow path through which air passes toward the second main body air suction port may be formed between the second outer surface of the device main body and the second exterior panel. A second air suction port for introducing air to the second air flow path may be formed between an edge of the second exterior panel and the device main body. The auxiliary air flow path may be positioned between the second air suction port and the second main body air suction port.
(12) In the electronic device according to (1) to (11), the cooling fan may include an impeller, and may be disposed with the impeller rotatable about an axis extending along the first direction. An angle range of the auxiliary air flow path in a circumferential direction centered on the axis may be equal to or larger than 10 degrees.
(13) In the electronic device according to (1) to (12), the auxiliary air flow path may be positioned between a corner of the device main body and the first and second main body air suction ports. With this configuration, a region (region around the corner) that is likely to become a dead space in the device main body can effectively be used to form the auxiliary air flow path.

It is to be noted that the electronic device that is proposed by the present disclosure is not limited to the electronic device 10 explained so far, and various modifications can be made therefor.

The cooling fan 40 is disposed in the electronic device 10 with its axis Ax1 extending along the up-down direction, for example. The position of the cooling fan 40 is, however, not limited to this.

By way of example, the cooling fan 40 may be disposed in the device main body 20 with its axis Ax1 set horizontally, or with the axis Ax1 extending along the circuit board 31. The position of the cooling fan 40 is not necessarily set between the main body air suction ports 22e and 23f. Further, a plurality of the cooling fans 40 may be disposed in the device main body 2. In this case, the plurality of cooling fans 40 may be disposed with the respective axes Ax1 extending along the up-down direction, or with the respective axes Ax1 extending along the circuit board 31. Also in such a case, if there is a difference in air suction performance between the two main body air suction ports 22e and 23f, an amount of air corresponding to the difference can be provided through the auxiliary air flow path Pc.

In addition to the auxiliary air flow path Pc (see FIG. 8), the panel air suction ports Se and Sf formed in the exterior panels 51 and 52 are included in the electronic device 10. However, the panel air suction ports Se and Sf are not necessarily included in the electronic device 10. In this case, the exterior panels 51 and 52 may be formed integrally without the portion panel 51R, 51L, 52R, or 52L.

## Claims

1. An electronic device comprising:
a cooling fan; and
a device main body that accommodates the cooling fan,
wherein
the device main body has
a first outer surface that is an outer surface on a first side in a first direction,
a second outer surface that is an outer surface on a second side which is opposite to the first side in the first direction,
a first main body air suction port that is formed in the first outer surface and that introduces air toward the cooling fan,
a second main body air suction port that is formed in the second outer surface and that introduces air toward the cooling fan, and
an auxiliary air flow path that extends through the device main body in the first direction and that allows an air flow from one of the first side and the second side in the device main body to the other side.

2. The electronic device according to claim 1, wherein
the cooling fan includes an impeller that is rotatable about an axis extending along the first direction, and is positioned between the first main body air suction port and the second main body air suction port.

3. The electronic device according to claim 2, wherein
the impeller has a plurality of fins, and
the impeller has a first end in the first direction, a second end that is an end opposite to the first end, and a guide section that is positioned between the first end and the second end and couples the plurality of fins to each other to guide air outwardly in a radial direction.

4. The electronic device according to claim 3, wherein
the guide section is positioned on the first side with respect to a center of the impeller in the first direction, and
air flows from the first side to the second side in the device main body via the auxiliary air flow path.

5. The electronic device according to claim 1, wherein
the device main body has a housing, and
the housing has a tubular flow path wall constituting the auxiliary air flow path.

6. The electronic device according to claim 1, comprising:
a first exterior panel that covers the first outer surface of the device main body, wherein
a first air flow path through which air passes toward the first main body air suction port is formed between the first outer surface of the device main body and the first exterior panel.

7. The electronic device according to claim 1, comprising:
a first exterior panel that covers the first outer surface of the device main body, wherein
the first exterior panel covers the auxiliary air flow path.

8. The electronic device according to claim 6, comprising:
a second exterior panel that covers the second outer surface of the device main body, wherein
a second air flow path through which air passes toward the second main body air suction port is formed between the second outer surface of the device main body and the second exterior panel.

9. The electronic device according to claim 8, wherein
the auxiliary air flow path connects the first air flow path to the second air flow path.

10. The electronic device according to claim 6, wherein
a first air suction port for introducing air to the first air flow path is formed between an edge of the first exterior panel and the device main body, and
the auxiliary air flow path is positioned between the first air suction port and the first main body air suction port.

11. The electronic device according to claim 10, comprising:
a second exterior panel that covers the second outer surface of the device main body, wherein
a second air flow path through which air passes toward the second main body air suction port is formed between the second outer surface of the device main body and the second exterior panel,
a second air suction port for introducing air to the second air flow path is formed between an edge of the second exterior panel and the device main body, and
the auxiliary air flow path is positioned between the second air suction port and the second main body air suction port.

12. The electronic device according to claim 1, wherein
the cooling fan includes an impeller, and is disposed with the impeller rotatable about an axis extending along the first direction, and
an angle range of the auxiliary air flow path in a circumferential direction centered on the axis is equal to or larger than 10 degrees.

13. The electronic device according to claim 1, wherein
the auxiliary air flow path is positioned between a corner of the device main body and the first and second main body air suction ports.
